# EUROPEAN PATENT APPLICATION

(11) **EP 4 851 652 A1**
(43) Date of publication of application: **09.12.2026**
(21) Application number: 25196307.0
(22) Date of filing: 18.08.2025
(51) Int. Cl.: G01R 33/00, G01R 33/07

(54) **METHOD FOR HALL-SENSOR DEMAGNETIZATION, PROCESSING MODULE, AND MOBILE LIGHTING DEVICE**

(30) Priority: 03.06.2025 CN 202510731315
(71) Applicant: Li, Wenjie, Guangzhou, Guangdong 510600 (CN)
(72) Inventor: Li, Wenjie, Guangzhou, Guangdong 510600 (CN)
(74) Representative: Isern Patentes y Marcas S.L.

(57) **Abstract**

The present disclosure relates to the technical field of resisting magnetic interference in hall sensors, in particularly to a method for hall-sensor demagnetization, a processing module, and a mobile lighting device. The method includes following steps: detecting whether hall sensors activated by an external magnetic field in a preset hall-sensor setting area exist; if exist, obtaining quantity information of the hall sensors activated by the external magnetic field in the hall-sensor setting area; comparing the quantity information with a set threshold; and, if the quantity information exceeds the set threshold, determining the hall sensors in the hall-sensor setting area are subject to strong magnetic interference, and blocking signal outputs of each hall sensor in the hall-sensor setting area. By determining whether the magnetic field interference exists through the quantity information of the activated hall sensors affected by the external magnetic field, avoiding hall sensors outputting error signals when subject to the external strong magnetic interference is achieved, thereby improving the anti-interference ability of hall sensors.

## Description

### FIELD

The present disclosure relates to the technical field of resisting magnetic interference in hall sensors, in particularly to a method for hall-sensor demagnetization, a processing module, and a mobile lighting device.

### BACKGROUND

Conventional hall switches rely on hall elements to detect magnetic-field changes. Output signals of the hall elements are directly affected by strength of an external magnetic field. Therefore, when external strong magnetic interference (such as artificially placing a permanent magnet) exists, the hall elements cannot distinguish between effective signals and interference signals, resulting in false triggering or triggering failure.

Therefore, the prior art still needs to be improved and developed.

### SUMMARY

In view of the above-mentioned defects of the prior art, the present disclosure provides a method for hall-sensor demagnetization, a processing module, and a mobile lighting device to solve the problem that hall sensors in the prior art are unable to distinguish between effective signals and interference signals when subject to external strong magnetic interference in the prior art.

The technical solutions of the present disclosure are as follows.

In a first aspect, the present disclosure provides a method for hall-sensor demagnetization, including following steps:
detecting whether hall sensors activated by an external magnetic field in a preset hall-sensor setting area exist;
if exist, obtaining quantity information of the hall sensors activated by the external magnetic field in the hall-sensor setting area;
comparing the quantity information with a set threshold; and,
if the quantity information exceeds the set threshold, determining the hall sensors in the hall-sensor setting area are subject to strong magnetic interference, and blocking signal outputs of each hall sensor in the hall-sensor setting area.

In some embodiments, in the step of comparing the quantity information with a set threshold, the set threshold is one.

In some embodiments, after the step of obtaining quantity information of the hall sensors activated by the external magnetic field in the hall-sensor setting area, the method further includes following steps:
determining whether the quantity information of the hall sensors activated by the external magnetic field is one; and,
if a quantity of the hall sensors activated by the external magnetic field is greater than one, determining the hall sensors in the hall-sensor setting area are subject to the strong magnetic interference, and blocking the signal outputs of each hall sensor in the hall-sensor setting area.

In some embodiments, the hall-sensor setting area is provided with a first hall-sensor group and a second hall-sensor group, the first hall-sensor group comprises a plurality of first hall sensors arranged with intervals, the second hall-sensor group comprises a plurality of second hall sensors, and the second hall sensors are arranged between adjacent two first hall sensors and arranged with intervals; and,
the step of detecting whether hall sensors activated by an external magnetic field in a preset hall-sensor setting area exist includes following steps:
detecting whether the second hall sensors activated by the external magnetic field in the hall-sensor setting area exist;
if the second hall sensors activated by the external magnetic field in the hall-sensor setting area exist, controlling to stop the signal outputs of each first hall sensor in the hall-sensor setting area; and,
if the second hall sensors activated by the external magnetic field in the hall-sensor setting area do not exist, detecting whether the first hall sensors activated by the external magnetic field in the hall-sensor setting area exist.

In some embodiments, after the step of comparing the quantity information with a set threshold, the method further includes following steps:
if the quantity information does not exceed the set threshold, marking the hall sensors activated by the external magnetic field as activated hall sensors;
when other hall sensors different from the marked activated hall sensors acquire the external magnetic field, marking the hall sensors acquiring the external magnetic field as hall sensors to be activated; and,
when the hall sensors to be activated being adjacent hall sensors to the activated hall sensors is detected, blocking signal outputs of the activated hall sensors, and activating the hall sensors to be activated.

In some embodiments, when the hall sensors to be activated being not adjacent hall sensors to the activated hall sensors is detected, the external strong magnetic interference existing is determined and signal outputs of the hall sensors to be activated are blocked.

In some embodiments, before the step of detecting whether hall sensors activated by an external magnetic field in a preset hall-sensor setting area exist, the method further includes following step:
determining whether the hall-sensor setting area is in an unlocked state, wherein the unlocked state refers to the hall sensors configured to output a control signal in the hall-sensor setting area being in the unlocked state.

In some embodiments, after the step of determining the hall sensors in the hall-sensor setting area are subject to strong magnetic interference, and blocking signal outputs of each hall sensor in the hall-sensor setting area, the method further includes following step:
after setting a duration, re detecting whether the hall sensors activated by the external magnetic field in the preset hall-sensor setting area exist.

In a second aspect, the present disclosure provides a processing module, including a memory and a processor, where the memory stores a computer program, and when the computer program is executed by the processor, the steps of the method for hall-sensor demagnetization as described above are implemented.

In third aspect, the present disclosure provides a mobile lighting device, including the processing module as described above.

The present disclosure provides a method for hall-sensor demagnetization, a processing module, and a mobile lighting device. The method for hall-sensor demagnetization includes following steps: detecting whether hall sensors activated by an external magnetic field in a preset hall-sensor setting area exist; if exist, obtaining quantity information of the hall sensors activated by the external magnetic field in the hall-sensor setting area; comparing the quantity information with a set threshold; and, if the quantity information exceeds the set threshold, determining the hall sensors in the hall-sensor setting area are subject to strong magnetic interference, and blocking signal outputs of each hall sensor in the hall-sensor setting area. The present disclosure, by obtaining corresponding quantity information of activated hall sensors affected by an external magnetic field, determining whether external magnetic field interference exists based on the quantity information of the activated hall sensors, and blocking signal outputs of all hall sensors when it is determined that the magnetic field interference exists, achieves avoiding hall sensors outputting error signals when subject to the external strong magnetic interference, thereby improving the anti-interference ability of hall sensors.

### BRIEF DESCRIPTION OF THE DRAWINGS

In order to provide a clearer explanation of the technical solutions in the embodiments of the present disclosure or in the prior art, a brief description is given to the accompanying drawings required for the description of the present embodiments or the prior art. Obviously, the accompanying drawings are only some embodiments of the present disclosure. For those ordinary skilled in the art, other drawings can be obtained based on the accompanying drawings without any creative labor.
FIG. 1 is a flowchart of a method for hall-sensor demagnetization in the present disclosure.
FIG. 2 is a schematic diagram of structures of a button and a first hall sensor in one embodiment of the present disclosure.
FIG. 3 is a schematic diagram of distribution of a first hall-sensor group and a second hall-sensor group in one embodiment of the present disclosure.
FIG. 4 is a circuit block diagram of the first hall sensor, a second hall sensor, and a processing module in one embodiment of the present disclosure.
FIG. 5 is a circuit schematic diagram of the first hall sensor and the second hall sensor in one embodiment of the present disclosure.

Numeral marks in the figures: 100, first hall-sensor group; 110, first hall sensor; 200, second hall-sensor group; 210, second hall sensor; 300, processing module; 400, button; 500, magnet.

### DETAILED DESCRIPTION OF THE EMBODIMENTS

The present disclosure provides a method for hall-sensor demagnetization, a processing module, and a mobile lighting device. In order to make the purposes, technical solutions, and effects of the present disclosure clearer and more specific, further detailed explanations of the present disclosure with reference to the accompanying drawings and examples are provided as follows. It should be understood that the specific embodiments described herein are only used to explain the present disclosure and are not intended to limit the present disclosure.

In the implementations and protection scope of the present disclosure, unless there are special limitations on articles in the text, "an", "a", "said", and "the" may include plural forms. If there are descriptions related to "first", "second", etc. in the embodiments of the present disclosure, the descriptions of "first", "second", etc. are only for descriptive purposes and cannot be understood as indicating or implying their relative importance or implying the number of technical features indicated. Therefore, the features that are limited to "first", "second", etc. can explicitly or implicitly include at least one of these features.

It should be further understood that the terms "include" and "comprise" used in the specification of the present disclosure refers to the presence of the features, integers, steps, operations, elements, and/or components, but does not exclude the presence or addition of one or more other features, integers, steps, operations, elements, components, and/or groups thereof. It should be understood that when a component is "connected" or "coupled" to another component, the component may be directly connected or coupled to the another component, or there may be intermediate components present. In addition, the term "connection" or "coupling" used here may include wireless connection or wireless coupling. The term 'and/or' used here includes all or any combination of one or more units listed in association with each other.

Those skilled in the art can understand that, unless otherwise defined, all terms used here (including technical and scientific terms) have the same meaning as those generally understood by those ordinary skilled in the art to which the present disclosure belongs. It should further be understood that terms such as those defined in general dictionaries should be understood to have meanings consistent with those in the context of the prior art, and unless specifically defined as here, they will not be interpreted with idealized or overly formal meanings.

In addition, the technical solutions between various embodiments can be combined with each other, but they must be based on the ability of those ordinary skilled in the art to implement them. When a combination of technical solutions is contradictory or impossible to implement, it should be considered that the combination of technical solutions does not exist and is not within the protection scope required by the present disclosure.

Through applicant's researches, it is found that mobile lighting devices and other devices can use hall sensors to adjust gears, such as achieving lock-mode control and brightness-mode control. Conventional hall switches rely on hall elements to detect magnetic-field changes. Output signals of the hall elements are directly affected by strength of an external magnetic field. Therefore, when external strong magnetic interference (such as artificially placing a permanent magnet) exists, the hall elements cannot distinguish between effective signals and interference signals, resulting in false triggering or triggering failure. For example, it can cause the mobile lighting devices to be falsely triggered so as to be turned on, or brightness-mode adjustment cannot be achieved.

**In** view of the above-mentioned defects of the prior art, the present disclosure provides a method for hall-sensor demagnetization, a processing module, and a mobile lighting device. The present disclosure, by obtaining corresponding quantity information of activated hall sensors affected by an external magnetic field, determining whether external magnetic field interference exists based on the quantity information of the activated hall sensors, and blocking signal outputs of all hall sensors when it is determined that the magnetic field interference exists, achieves avoiding hall sensors outputting error signals when subject to the external strong magnetic interference, thereby improving the anti-interference ability of hall sensors. The present disclosure is particularly adaptable for mobile lighting devices.

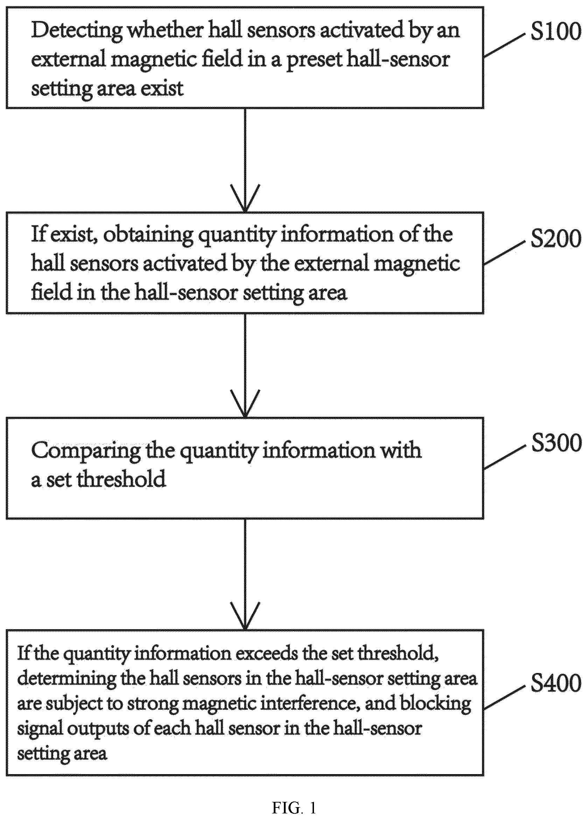

Referring to FIGs. 1 to 5, the present disclosure provides a preferred embodiment of a method for hall-sensor demagnetization.

In some embodiments, as shown in FIG. 1, the present disclosure provides a method for hall-sensor demagnetization, including S100, S200, S300, and S400.

S 100, detecting whether hall sensors activated by an external magnetic field in a preset hall-sensor setting area exist.

The hall-sensor setting area refers to a position area (needed to be set) of hall sensors which can output corresponding control signals. For a mobile lighting device, each hall sensor is arranged with intervals in the preset hall-sensor setting area of the mobile lighting device. The hall sensor arranged in a first position can be used to achieve a locking function, while the hall sensors arranged in sequence can be used to achieve a gear-adjustment function. For example, the second hall sensor is used to achieve first-gear adjustment, the third hall sensor is used to achieve second-gear adjustment, and the fourth hall sensor is used to achieve third-gear adjustment. The number of hall sensors can be set according to actual applications or functions needed to be implemented. When a hall sensor in the hall-sensor setting area is in a powered state, the hall sensor will be activated when affected by an external magnetic field.

S200, if exist, obtaining quantity information of the hall sensors activated by the external magnetic field in the hall-sensor setting area.

The quantity information refers to the number of the hall sensors activated by the external magnetic field in the hall-sensor setting area. Taking the mobile lighting device as an example, the mobile lighting device has a processing module that is connected to each hall sensor and can detect activation states of hall sensors. If a hall sensor is detected to be activated by the external magnetic field, the hall sensor is included in the quantity information. For example, if one hall sensor is detected to be activated by the external magnetic field, the quantity information is 1. If three hall sensors are detected to be activated by the external magnetic field, the quantity information is 3.

S300, comparing the quantity information with a set threshold.

Taking the mobile lighting device as an example, the processing module of the mobile lighting device is preset with the set threshold. The processing module compares the detected quantity information with the preset threshold each time and obtains a comparison result. In one implementation, the set threshold may be set as one, i.e. one sensor.

S400, if the quantity information exceeds the set threshold, determining the hall sensors in the hall-sensor setting area are subject to strong magnetic interference, and blocking signal outputs of each hall sensor in the hall-sensor setting area.

When the number of the activated hall sensors affected by the external magnetic field in the hall-sensor setting area exceeds the set threshold, it can be determined that currently the strong magnetic interference exists, and the signal outputs of the hall sensors in the hall-sensor setting area need to be blocked. When the number of the activated hall sensors affected by the external magnetic field in the hall-sensor setting area does not exceed the set threshold, it is determined that currently no strong magnetic interference exists.

In the above technical solution, the present disclosure, by obtaining corresponding quantity information of activated hall sensors affected by an external magnetic field, determining whether external magnetic field interference exists based on the quantity information of the activated hall sensors, and blocking signal outputs of all hall sensors when it is determined that the magnetic field interference exists, achieves avoiding hall sensors outputting error signals when subject to the external strong magnetic interference, thereby improving the anti-interference ability of hall sensors. The present disclosure is particularly adaptable for mobile lighting devices.

In some embodiments, after the step of obtaining quantity information of the hall sensors activated by the external magnetic field in the hall-sensor setting area, the present method further includes the following steps:
S210, determining whether the quantity information of the hall sensors activated by the external magnetic field is one; and,
S220, if a quantity of the hall sensors activated by the external magnetic field is greater than one, determining the hall sensors in the hall-sensor setting area are subject to the strong magnetic interference, and blocking the signal outputs of each hall sensor in the hall-sensor setting area.

In this embodiment, the set threshold is one. After obtaining the quantity information of the hall sensors activated by the external magnetic field, it is determined whether single one hall sensor is activated. If the quantity information is greater than one, i.e. two or more than two, it can be determined that the hall sensors in the hall-sensor setting area are affected by the strong magnetic interference. At this time, it is necessary to block the signal outputs of each hall sensor to avoid the hall sensors outputting error signals.

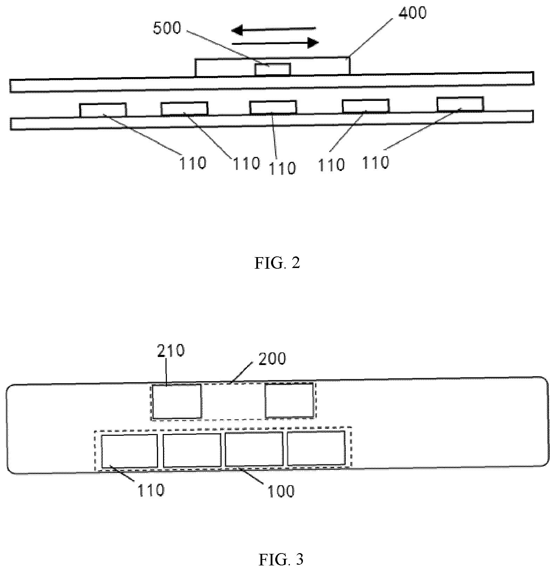

In some embodiments, as shown in FIGs. 2 to 5, the hall-sensor setting area is provided with a first hall-sensor group 100 and a second hall-sensor group 200. The first hall-sensor group 100 includes a plurality of first hall sensors 110 arranged with intervals, and the second hall-sensor group 200 includes a plurality of second hall sensors 210. The second hall sensors 210 are arranged between adjacent two first hall sensors 110 and arranged with intervals.

The step of detecting whether hall sensors activated by an external magnetic field in a preset hall-sensor setting area exist includes the following steps:
S110, detecting whether the second hall sensors activated by the external magnetic field in the hall-sensor setting area exist;
S120, if the second hall sensors activated by the external magnetic field in the hall-sensor setting area exist, controlling to stop the signal outputs of each first hall sensor in the hall-sensor setting area,
S130, if the second hall sensors activated by the external magnetic field in the hall-sensor setting area do not exist, detecting whether the first hall sensors activated by the external magnetic field in the hall-sensor setting area exist.

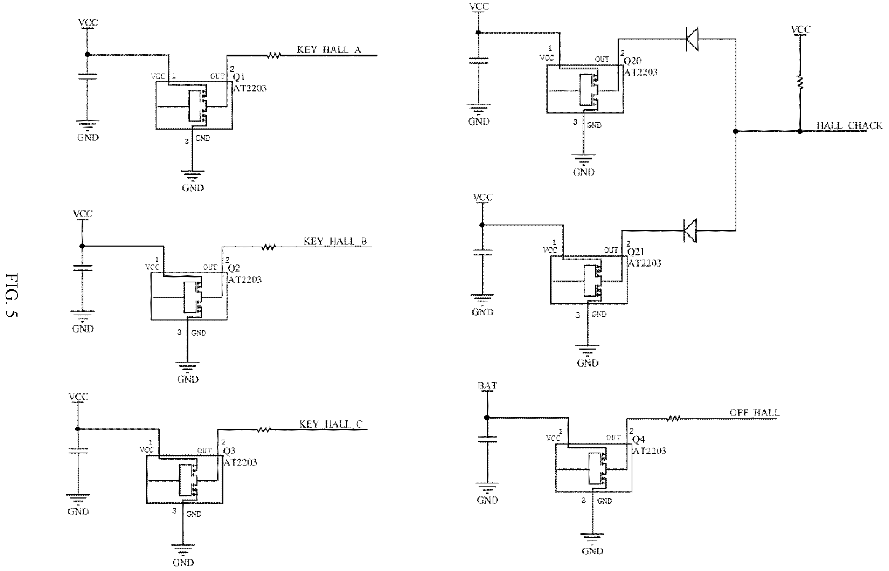

In this embodiment, a first hall-sensor group 100 and a second hall-sensor group 200 are set in the hall-sensor setting area. The hall sensors in the first hall-sensor group 100 can send corresponding control signals to achieve corresponding functions, such as gear adjustment, etc. As shown in FIG. 5, hall sensor Q4 in FIG. 5 is used to achieve a locking function, hall sensor Q1 is used to achieve first-gear function, hall sensor Q2 is used to achieve second-gear function, and hall sensor Q3 is used to achieve third-gear function. The second hall-sensor group 200 is used for auxiliary activation determination. Hall sensors Q20 and Q21 in FIG. 5 are the second hall sensors.

As shown in FIG. 2, a button 400 is set in the hall-sensor setting area and is located above the first hall-sensor group 100. A magnet 500 is set inside the button 400 to activate the first hall sensors 110. The first hall sensors 110 are set with intervals; and when sliding the button 400, different first hall sensors 110 can be activated. A space distance between adjacent two first hall sensors 110 is less than a preset distance, and the preset distance can ensure that when one of the two first hall sensors 110 is activated, the other adjacent hall sensor will not be activated by mistakenly recognizing a signal of the magnet 500. A space distance between the second hall-sensor group 200 and the first hall-sensor group 100 cannot be less than the preset distance to prevent the magnet 500 in the button 400 above the first hall sensors 110 from causing signal interference to the second hall-sensor group 200.

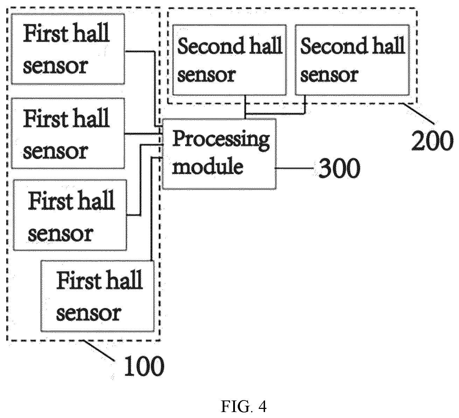

The second hall-sensor group 200 serves as a hall sensor for auxiliary activation determination, and the second hall sensors 210 are connected to the processing module 300. The second hall sensors 210 are distributed between adjacent two first hall sensors 110, as shown in FIGs. 3 and 4. When the second hall sensors 210 in the second hall-sensor group 200 is detected to be activated by the external magnetic field, the signal outputs of the first hall sensors 110 are directly stopped. If no second hall sensor 210 is detected to be activated, the quantity information of the first hall sensors 110 activated by the magnetic field signal is further detected.

In some embodiments, after the step of comparing the quantity information with a set threshold, the present method further includes the following steps:
S310, if the quantity information does not exceed the set threshold, marking the hall sensors activated by the external magnetic field as activated hall sensors;
S320, when other hall sensors different from the marked activated hall sensors acquire the external magnetic field, marking the hall sensors acquiring the external magnetic field as hall sensors to be activated; and,
S330, when the hall sensors to be activated being adjacent hall sensors to the activated hall sensors is detected, blocking signal outputs of the activated hall sensors, and activating the hall sensors to be activated.

In this embodiment, when it is detected that the hall sensors (i.e. the first hall sensors used to output a control signal) activated by the external magnetic field are single one, the activated first hall sensor will is the activated hall sensor. When other hall sensors, i.e. the other first hall sensors in the first hall-sensor group, acquire the external magnetic field, marking the first hall sensors acquiring the external magnetic field as the hall sensor to be activated. Afterwards, the positions of the hall sensors to be activated are detected to determine whether the hall sensors to be activated are the first hall sensors adjacent to the activated hall sensors. If the hall sensors to be activated are the first hall sensors adjacent to the activated hall sensors, the signal outputs of the activated hall sensors are blocked and the hall sensors to be activated are activated, so as to ensure that each first hall sensor is activated in an arrangement sequence. It should be noted that, in order to ensure that each hall sensor is activated in the sequence of 1-2-3-4 (adjacent), if two sensors (such as 1, 3) are activated while one middle sensor (such as middle 2 between 1 and 3) located between the two sensors is not activated without following this sequence, it proves that the middle sensor between the two sensors may be affected by the external magnetic field and fails. In addition, when the hall sensors are used to achieve a gear-adjustment function, if the first hall sensors of the first hall-sensor group are not activated in sequence, gear jumping may occur.

When it is detected that the hall sensors to be activated are not adjacent hall sensors to the activated hall sensors, it is determined that the external strong magnetic interference exists and the signal outputs of the hall sensors to be activated are blocked. It should be noted that the hall sensors include a hall sensor with a linear output function and a hall sensor outputting a one-time signal. In this embodiment, the hall sensor is used as the hall sensor with a linear output function, which can continuously output signals when activated; therefore, after blocking the signal outputs of the hall sensors to be activated, the signal outputs of the activated hall sensors can be maintained.

In some embodiments, before the step of detecting whether hall sensors activated by an external magnetic field in a preset hall-sensor setting area exist, the method further includes the following step:
S101, determining whether the hall-sensor setting area is in an unlocked state, where the unlocked state refers to the hall sensors configured to output a control signal in the hall-sensor setting area being in the unlocked state.

In this embodiment, there is a locking mechanism for the hall sensors in the hall-sensor setting area. Generally, first one of the first hall sensors in the first hall-sensor group is configured to send or unlock signals, and the other first hall sensors in the first hall-sensor group are locked or unlocked as a whole. When it is necessary to detect whether the hall sensors activated by the external magnetic field in the hall-sensor setting area exist, firstly the first hall sensors in the hall-sensor setting area should be in the unlocked state.

In some embodiments, after the step of determining the hall sensors in the hall-sensor setting area are subject to strong magnetic interference, and blocking signal outputs of each hall sensor in the hall-sensor setting area, the method further includes the following step:
S500, after setting a duration, re detecting whether the hall sensors activated by the external magnetic field in the preset hall-sensor setting area exist.

In this embodiment, when the external magnetic field may have disappeared and the signal outputs of each hall sensor in the hall-sensor setting area needs to be unblocked, it is necessary to wait for a certain duration before re detecting the hall sensors activated by the external magnetic field in the hall-sensor setting area to prevent interference from the original external magnetic field from affecting the hall sensors.

In some embodiments, the present disclosure further provides a processing module including a memory and a processor. The memory stores a computer program. When the computer program is executed by the processor, the steps of the method for hall-sensor demagnetization as described above are implemented. As described in an embodiment of a method for hall-sensor demagnetization, it is not repeated here.

In some embodiments, the present disclosure further provides a mobile lighting device including the processing module as described above. As described in an embodiment of a method for hall-sensor demagnetization, it is not repeated here.

In summary, the method for hall-sensor demagnetization, the processing module, and the mobile lighting device all provided by the present disclosure have the following beneficial effects:

By obtaining corresponding quantity information of activated hall sensors affected by an external magnetic field, determining whether external magnetic field interference exists based on the quantity information of the activated hall sensors, and blocking signal outputs of all hall sensors when it is determined that the magnetic field interference exists, the present disclosure achieves avoiding hall sensors outputting error signals when subject to the external strong magnetic interference, thereby improving the anti-interference ability of hall sensors. The present disclosure is particularly adaptable for mobile lighting devices.

It should be understood that the applications of the present disclosure are not limited to the above examples. For those skilled in the art, improvements or transformations can be made based on the above description, and all such improvements and transformations should fall within the protection scope of the claims attached to the present disclosure.

## Claims

1. A method for hall-sensor demagnetization, comprising following steps:
detecting whether hall sensors activated by an external magnetic field in a preset hall-sensor setting area exist;
if exist, obtaining quantity information of the hall sensors activated by the external magnetic field in the hall-sensor setting area;
comparing the quantity information with a set threshold; and,
if the quantity information exceeds the set threshold, determining the hall sensors in the hall-sensor setting area are subject to strong magnetic interference, and blocking signal outputs of each hall sensor in the hall-sensor setting area.

2. The method for hall-sensor demagnetization according to claim 1, wherein in the step of comparing the quantity information with a set threshold, the set threshold is one.

3. The method for hall-sensor demagnetization according to claim 2, wherein after the step of obtaining quantity information of the hall sensors activated by the external magnetic field in the hall-sensor setting area, the method further comprises following steps:
determining whether the quantity information of the hall sensors activated by the external magnetic field is one; and,
if a quantity of the hall sensors activated by the external magnetic field is greater than one, determining the hall sensors in the hall-sensor setting area are subject to the strong magnetic interference, and blocking the signal outputs of each hall sensor in the hall-sensor setting area.

4. The method for hall-sensor demagnetization according to claim 1, wherein the hall-sensor setting area is provided with a first hall-sensor group and a second hall-sensor group, the first hall-sensor group comprises a plurality of first hall sensors arranged with intervals, the second hall-sensor group comprises a plurality of second hall sensors, and the second hall sensors are arranged between adjacent two first hall sensors and arranged with intervals; and,
the step of detecting whether hall sensors activated by an external magnetic field in a preset hall-sensor setting area exist comprises following steps:
detecting whether the second hall sensors activated by the external magnetic field in the hall-sensor setting area exist;
if the second hall sensors activated by the external magnetic field in the hall-sensor setting area exist, controlling to stop the signal outputs of each first hall sensor in the hall-sensor setting area; and,
if the second hall sensors activated by the external magnetic field in the hall-sensor setting area do not exist, detecting whether the first hall sensors activated by the external magnetic field in the hall-sensor setting area exist.

5. The method for hall-sensor demagnetization according to claim 1, wherein after the step of comparing the quantity information with a set threshold, the method further comprises following steps:
if the quantity information does not exceed the set threshold, marking the hall sensors activated by the external magnetic field as activated hall sensors;
when other hall sensors different from the marked activated hall sensors acquire the external magnetic field, marking the hall sensors acquiring the external magnetic field as hall sensors to be activated; and,
when the hall sensors to be activated being adjacent hall sensors to the activated hall sensors is detected, blocking signal outputs of the activated hall sensors, and activating the hall sensors to be activated.

6. The method for hall-sensor demagnetization according to claim 5, wherein when the hall sensors to be activated being not adjacent hall sensors to the activated hall sensors is detected, the external strong magnetic interference existing is determined and signal outputs of the hall sensors to be activated are blocked.

7. The method for hall-sensor demagnetization according to claim 1, wherein before the step of detecting whether hall sensors activated by an external magnetic field in a preset hall-sensor setting area exist, the method further comprises following step:
determining whether the hall-sensor setting area is in an unlocked state, wherein the unlocked state refers to the hall sensors configured to output a control signal in the hall-sensor setting area being in the unlocked state.

8. The method for hall-sensor demagnetization according to claim 1, wherein after the step of determining the hall sensors in the hall-sensor setting area are subject to strong magnetic interference, and blocking signal outputs of each hall sensor in the hall-sensor setting area, the method further comprises following step:
after setting a duration, re detecting whether the hall sensors activated by the external magnetic field in the preset hall-sensor setting area exist.

9. A processing module, comprising a memory and a processor, wherein the memory stores a computer program, and when the computer program is executed by the processor, the steps of the method for hall-sensor demagnetization according to any one of claims 1 to 8 are implemented.

10. A mobile lighting device, comprising the processing module according to claim 9.

## Amended claims

### Amended claims in accordance with Rule 137(2) EPC.

1. A method for protection and prevention in the hall-sensor magnetization, comprising following steps:
detecting whether hall sensors activated by an external magnetic field in a preset hall-sensor setting area exist;
if exist, obtaining quantity information of the number of the hall sensors activated by the external magnetic field in the hall-sensor setting area;
comparing the quantity information with a set threshold; and,
if the quantity information exceeds the set threshold, determining the hall sensors in the hall-sensor setting area are subject to strong magnetic interference, and blocking signal outputs of each hall sensor in the hall-sensor setting area;
**characterized in that** the hall-sensor setting area is provided with a first hall-sensor group (100) and a second hall-sensor group (200), the first hall-sensor group (100) comprises a plurality of first hall sensors (110) arranged with intervals, the second hall-sensor group (200) comprises a plurality of second hall sensors (210), and the second hall sensors (210) are arranged between adjacent two first hall sensors (110) and arranged with intervals; and,
the step of detecting whether hall sensors activated by an external magnetic field in a preset hall-sensor setting area exist comprises following steps:
detecting whether the second hall sensors (210) activated by the external magnetic field in the hall-sensor setting area exist;
if the second hall sensors (210) activated by the external magnetic field in the hall-sensor setting area exist, controlling to stop the signal outputs of each first hall sensor (110) in the hall-sensor setting area; and,
if the second hall sensors (210) activated by the external magnetic field in the hall-sensor setting area do not exist, detecting whether the first hall sensors (110) activated by the external magnetic field in the hall-sensor setting area exist.

2. The method for protection and prevention in the hall-sensor magnetization according to claim 1, wherein in the step of comparing the quantity information with a set threshold, the set threshold is one.

3. The method for protection and prevention in the hall-sensor magnetization according to claim 2, wherein after the step of obtaining quantity information of the hall sensors activated by the external magnetic field in the hall-sensor setting area, the method further comprises following steps:
determining whether the quantity information of the hall sensors activated by the external magnetic field is one; and,
if a quantity of the hall sensors activated by the external magnetic field is greater than one, determining the hall sensors in the hall-sensor setting area are subject to the strong magnetic interference, and blocking the signal outputs of each hall sensor in the hall-sensor setting area.

4. The method for protection and prevention in the hall-sensor magnetization according to claim 1, wherein after the step of comparing the quantity information with a set threshold, the method further comprises following steps:
if the quantity information does not exceed the set threshold, marking the hall sensors activated by the external magnetic field as activated hall sensors;
when other hall sensors different from the marked activated hall sensors acquire the external magnetic field, marking the hall sensors acquiring the external magnetic field as hall sensors to be activated; and,
when the hall sensors to be activated being adjacent hall sensors to the activated hall sensors is detected, blocking signal outputs of the activated hall sensors, and activating the hall sensors to be activated.

5. The method for protection and prevention in the hall-sensor magnetization according to claim 4, wherein when the hall sensors to be activated being not adjacent hall sensors to the activated hall sensors is detected, the external strong magnetic interference existing is determined and signal outputs of the hall sensors to be activated are blocked.

6. The method for protection and prevention in the hall-sensor magnetization according to claim 1, wherein before the step of detecting whether hall sensors activated by an external magnetic field in a preset hall-sensor setting area exist, the method further comprises following step:
determining whether the hall-sensor setting area is in an unlocked state, wherein the unlocked state refers to the hall sensors configured to output a control signal in the hall-sensor setting area being in the unlocked state.

7. The method for protection and prevention in the hall-sensor magnetization according to claim 1, wherein after the step of determining the hall sensors in the hall-sensor setting area are subject to strong magnetic interference, and blocking signal outputs of each hall sensor in the hall-sensor setting area, the method further comprises following step:
after setting a duration, re detecting whether the hall sensors activated by the external magnetic field in the preset hall-sensor setting area exist.

8. A processing module (300), comprising a memory and a processor, wherein the memory stores a computer program, and when the computer program is executed by the processor, the steps of the method for protection and prevention in the hall-sensor magnetization according to any one of claims 1 to 7 are implemented.

9. A mobile lighting device, comprising the processing module (300) according to claim 8.
